# EUROPÄISCHE PATENTSCHRIFT

(11) **EP 1 203 241 B1**
(45) Veröffentlichungstag und Bekanntmachung des Hinweises auf die Patenterteilung: **31.01.2007**
(21) Anmeldenummer: 00949409.7
(22) Anmeldetag: 27.07.2000
(51) Int. Cl.: G01R 33/28

(54) **HOCHDRUCKPOLARISATOR ZUR HYPERPOLARISIERUNG DER KERNSPINS VON EDELGASEN**
HIGH PRESSURE POLARIZER FOR HYPERPOLARIZING THE NUCLEAR SPIN OF NOBLE GASES
POLARISATEUR HAUTE PRESSION POUR HYPERPOLARISATION DU SPIN NUCLEAIRE DE GAZ RARES

(30) Priorität: 09.08.1999 DE 19937566
(43) Veröffentlichungstag der Anmeldung: 08.05.2002
(73) Patentinhaber: Forschungszentrum Jülich GmbH, 52425 Jülich (DE)
(72) Erfinder: SHAH, Nadim, Joni, D-52441 Linnich-Boslar (DE); APPELT, Stephan, D-52428 Jülich (DE); ÜNLÜ, Timur, 42781 Haan (DE); HALLING, Horst, D-52459 Inden-Pier (DE); ZILLES, Karl, D-50859 Köln (DE)
(74) Vertreter: Gille Hrabal Struck Neidlein Prop Roos
(86) Internationale Anmeldenummer: PCT/EP2000/007217
(87) Internationale Veröffentlichungsnummer: WO 2001/011379

(56) Entgegenhaltungen:
- US-A- 5 642 625

## Beschreibung

Die Erfindung betrifft eine Vorrichtung mit den Merkmalen des Oberbegriffs des Anspruchs 1, bekannt aus US 5,642,625.

Neuere Entwicklungen in der Magnet Resonanz Tomographie (MRT) sowie in der Magnet Resonanz Spektroskopie (NMR) mit polarisierten Edelgasen lassen Anwendungen in der Medizin, in der Physik und in den Materialwissenschaften erwarten. Große Polarisationen von Kernspins von Edelgasen können durch optisches Pumpen mit Hilfe von Alkaliatomen erzielt werden, wie der Druckschrift Happer et al., Phys. Ref. A, 29, 3092 (1984) zu entnehmen ist. Typischerweise wird zur Zeit das Alkaliatom Rubidium in Anwesenheit eines Edelgases und Stickstoff eingesetzt. Auf diese Weise ist es möglich, eine Eiernspinpolarisation des Edelgases Xenon (¹²⁹Xe) von ca. 20 Prozent zu erreichen. Eine solche Kernspinpolarisation ist ca. 100 000 mal größer als die Gleichgewichtspolarisation in klinischen Magnet Resonanz Tomographen. Die damit verbundene drastische Steigerung des Signal - Rausch - Verhältnisses erklärt, weshalb in Zukunft neue Anwendungsmöglichkeiten in der Medizin, Wissenschaft und Technik erwartet werden.

Unter Polarisation wird der Grad der Ausrichtung (Ordnung) der Spins von Atomkernen oder Elektronen verstanden. 100 Prozent Polarisation bedeutet zum Beispiel, daß sämtliche Kerne oder Elektronen in gleicher Weise orientiert sind. Mit der Polarisation von Kernen oder Elektronen ist ein magnetisches Moment verbunden.

Polarisiertes Xenon wird zum Beispiel von einem Menschen inhaliert oder in ihn injiziert. 10 bis 15 Sekunden später sammelt sich das polarisierte Xenon im Gehirn an. Mit Hilfe der Magnetischen Resonanz Tomographie wird die Verteilung des Edelgases im Gehirn festgestellt. Das Ergebnis wird für weitere Analysen genutzt.

Die Wahl des Edelgases hängt vom Anwendungsfall ab. ¹²⁹Xenon weist eine große chemische Verschiebung auf. Wird Xenon z. B. auf einer Oberfläche adsorbiert, so verändert sich signifikant seine Resonanzfrequenz. Außerdem löst sich Xenon in fettliebenden (d. h.: lipophilen) Flüssigkeiten. Wenn derartige Eigenschaften erwünscht sind, wird Xenon eingesetzt.

Das Edelgas Helium löst sich kaum in Flüssigkeiten. Das Isotop ³Helium wird daher regelmäßig dann verwendet, wenn Hohlräume betroffen sind. Die Lunge eines Menschen stellt ein Beispiel für einen solchen Hohlraum dar.

Einige Edelgase weisen andere wertvolle Eigenschaften als die vorgenannten auf. So besitzen z. B. die Isotope ⁸³Krypton, ²¹Neon und ¹³¹Xenon ein Quadrupolmoment, welches z. B. für Experimente in der Grundlagenforschung bzw. in der Oberflächenphysik interessant sind. Diese Edelgase sind allerdings sehr teuer, so daß diese für Anwendungen, bei denen größere Mengen verwendet werden, ungeeignet sind.

Aus der Druckschrift "B. Driehuys et al., Appl. Phys. Lett. 69, 1668 (1996) ist bekannt, Edelgase auf folgende Weise in einem Polarisator zu polarisieren.

Mit Hilfe eines Lasers wird zirkular polarisiertes Licht bereitgestellt, also Licht, bei dem der Drehimpuls bzw. der Spin der Photonen alle in die gleiche Richtung zeigen. Der Drehimpuls der Photonen wird auf freie Elektronen von Alkaliatomen übertragen. Die Spins der Elektronen der Alkaliatome weisen somit eine große Abweichung vom thermischen Gleichgewicht auf. Die Alkaliatome sind folglich polarisiert. Durch einen Stoß von einem Alkaliatom mit einem Atom eines Edelgases wird die Polarisation des Elektronenspins vom Alkaliatom auf das Atom des Edelgases übertragen. Es entsteht so polarisiertes Edelgas.

Alkaliatome werden eingesetzt, da diese über ein großes optisches Dipolmoment verfügen, welches mit dem Licht wechselwirkt. Ferner weisen Alkaliatome jeweils ein freies Elektron auf, so daß keine nachteilhaften Wechselwirkungen zwischen zwei und mehr Elektronen pro Atom auftreten können.

Cäsium wäre ein besonders gut geeignetes Alkaliatom, welches gegenüber Rubidium zur Erzielung vorgenannter Wirkungen überlegen ist. Es stehen jedoch zur Zeit keine Laser mit genügend hoher Leistung zur Verfügung, wie sie für die Polarisation von Xenon mittels Cäsium benötigt würden. Es ist jedoch zu erwarten, daß in Zukunft Laser mit Leistungen um 100 Watt auf der Cäsiumwellenlänge entwickelt werden.. Dann wird voraussichtlich bevorzugt Cäsium für die Polarisation von Xenongas eingesetzt.

Gemäß dem Stand der Technik wird ein Gasgemisch unter einem Druck von typischerweise 7 bis 10 bar durch eine zylindrische Glaszelle langsam durchgeleitet. Das Gasgemisch besteht z. B. zu 98 Prozent aus ⁴Helium, einem Prozent Stickstoff bzw. einem Prozent Xenon. Die typischen Geschwindigkeiten des Gasgemisches betragen einige ccm pro Sekunde.

Das Gasgemisch durchströmt zunächst ein Gefäß (nachfolgend "Vorratsgefäß" genannt), in dem sich ca. ein Gramm Rubidium befindet. Das Vorratsgefäß mit dem darin befindlichen Rubidium wird zusammen mit der sich anschließenden Glaszelle auf ca. 100 bis 150 Grad Celsius erwärmt. Durch Bereitstellung dieser Temperaturen wird das Rubidium verdampft. Die Konzentration der verdampften Rubidium-Atome in der Gasphase wird durch die Temperatur im Vorratsgefäß bestimmt. Der Gasstrom transportiert die verdampften Rubidium - Atome von dem Vorratsgefäß in die zylindrische Probenzelle. Ein leistungsstarker, zirkular polarisierter Laser (100 Watt Leistung im kontinuierlichen Betrieb) durchstrahlt die Probenzelle, die im allgemeinen eine zylindrische Glaszelle ist, axial und pumpt optisch die Rubidium - Atome in einen hochpolarisierten Zustand. Die Wellenlänge des Lasers muß dabei auf die optische Absorptionslinie der Rubidium - Atome (D 1 - Linie) abgestimmt sein. Mit anderen Worten: Um die Polarisation vom Licht auf ein Alkaliatom optimal zu übertragen, muß die Frequenz des Lichts mit der Resonanzfrequenz des optischen Übergangs übereinstimmen. Die Probenzelle befindet sich in einem statischen magnetischen Feld B₀ von einigen 10 Gauss, das von Spulen - insbesondere einem sogenannten Helmholtzspulenpaar - erzeugt wird. Die Richtung des magnetischen Feldes verläuft parallel zur Zylinderachse der Probenzelle bzw. parallel zur Strahlrichtung des Lasers. Das Magnetfeld dient der Führung der polarisierten Atome.

Die durch das Licht des Lasers optisch hochpolarisierten Rubidium - Atome kollidieren in der Glaszelle u. a. mit den Xenon - Atomen und geben ihre hohe Polarisation an die Xenon - Atome ab. Am Ausgang der Probenzelle scheidet sich das Rubidium aufgrund des hohen Schmelzpunkts im Vergleich zu den Schmelzpunkten der übrigen Gase an der Wand ab. Das polarisierte Xenon bzw. das Restgasgemisch wird von der Probenzelle in eine Ausfriereinheit weitergeleitet. Diese besteht aus einem Glaskolben, dessen Ende in flüssigen Stickstoff getaucht ist. Der Glaskolben befindet sich ferner in einem Magnetfeld mit einer Stärke von 1000 bis 2000 Gauss. Das hochpolarisierte Xenon-Gas scheidet sich an der inneren Glaswand der Ausfriereinheit als Eis ab. Am Auslaß der Ausfriereinheit wird das restliche Gas (Helium und Stickstoff) über ein Nadelventil geleitet und schließlich abgelassen.

Die Flußgeschwindigkeit in der gesamten Anordnung kann über das Nadelventil gesteuert und mit einem Meßgerät gemessen werden. Steigt die Flußgeschwindigkeit zu sehr an, so verbleibt keine Zeit zur Übertragung der Polarisation von den Rubidium - Atomen auf die Xenon - Atome. Es wird also keine Polarisation erzielt. Ist die Flußgeschwindigkeit zu niedrig, so verstreicht zuviel Zeit, bis die gewünschte Menge an hochpolarisiertem Xenon eingefroren ist. Durch Relaxation nimmt die Polarisation der Xenon - Atome nämlich wieder ab. Die Relaxation der Xenon-Atome wird durch das Einfrieren sowie durch das starke Magnetfeld, welchem die Ausfriereinheit ausgesetzt ist, stark verlangsamt. Es ist daher erforderlich, nach der Polarisierung das Edelgas Xenon möglichst schnell und verlustfrei einzufrieren. Zwar kann die Relaxation durch das Einfrieren nicht vermieden werden. Es verbleiben jedoch noch 1 bis 2 Stunden Zeit, ehe die Xenon-Polarisation so stark abgenommen hat, daß eine weitere Verwendung des anfangs hochpolarisierten Gases nicht mehr möglich ist.

Ein Polarisator der vorgenannten Art weist stets Verbindungsstellen auf. Verbindungsstellen sind solche, bei denen wenigstens zwei Leitungen, durch die polarisiertes Gas geleitet wird, miteinander verbunden sind. Die Leitungen bestehen in der Regel aus Glas. Die Verbindung wird durch ein Verbindungselement wie z. B. Flansche hergestellt.

Das Licht des Lasers, der die Polarisation erzeugt, wird in der Probenzelle absorbiert. Die Intensität des Lichts und, damit der Grad der Polarisation der Alkaliatome in der Probenzelle nimmt entsprechend ab. Der Querschnitt der Probenzelle wird aus technischen Gründen im allgemeinen nicht.gleichmäßig durch das Licht des Lasers ausgeleuchtet. Folglich werden die Alkaliatome nicht gleichmäßig polarisiert. Wechselwirkungen mit den Wänden der Probenzelle verändern die Polarisation der Alkaliatome ebenfalls entlang des Querschnitts der Probenzelle. In der Probenzelle verändert sich die Polarisation der Alkaliatome folglich in Abhängigkeit vom Ort.

Um ein einzelnes freies Alkaliatom zu polarisieren, ist eine bestimmte Energie erforderlich. Diese erforderliche Energie entspricht der Resonanzfrequenz zur Anhebung des freien Elektrons des Alkaliatoms von einem Grundzustand in einen angeregten Zustand. Um die Energie von einem Laser auf das Alkaliatom optimal zu übertragen, muß die Frequenz des Lichts des Lasers auf die Resonanzfrequenz des Alkaliatoms abgestimmt werden. Preiswerte Laser senden ihr Licht innerhalb eines bestimmten Frequenzspektrums aus. Es handelt sich dabei also nicht um eine einzelne Frequenz, sondern um eine Verteilung von Frequenzen. Das zur Verfügung stehende Spektrum eines Lasers wird durch eine sogenannte Linienbreite charakterisiert. Um wirtschaftlich Alkaliatome zu polarisieren, werden Laser vorgesehen, deren Frequenz und Linienbreite auf die Resonanzfrequenz bzw. die optische Linienbreite des Alkaliatoms abgestimmt sind.

Um die Energie von einem Laser auf Alkaliatome besser übertragen zu können, sind während der Polarisation Stoßpartner für die Alkaliatome vorgesehen. Als Stoßpartner dienen insbesondere ⁴Helium - Atome. Durch die Wechselwirkung bzw. durch die Stöße mit den Helium-Atomen verbreitet sich die optische Linienbreite eines Alkaliatoms. Je breiter dieses atomare Spektrum ist, desto eher können spektral breite und damit preiswerte Laser eingesetzt werden.

Die Anzahl der Stöße zwischen einem Alkaliatom und einem Stoßpartner wie Helium ist um so höher, je höher der Druck ist. Für ⁴Helium zum Beispiel ist die Druckerverbreiterung der optischen Linienbreite des Alkaliatoms proportional zum Druck des Heliumgases. Außerdem besitzt Helium die wertvolle Eigenschaft, daß es nur wenig zerstörenden Einfluß auf die Polarisation der Alkaliatome hat. Bei der Polarisation von Alkaliatomen durch einen Laser wird daher regelmäßig mit einem Gasgemisch gearbeitet, welches zu 98 Prozent aus Helium besteht und einen Druck von ca. 10 bar besitzt.

Bei dem gemäß Stand der Technik eingesetzten 100 Watt starken Laser handelt es sich um einen glasfasergekoppelten Diodenlaser mit einer typischen Spektralbreite von 2 bis 4 Nanometern. Bei einem Gasdruck von 10 bar ist die Linienbreite des optischen Überganges von Rubidiumatomen auf ca. 0,3 Nanometer verbreitert. Daher wird in den vorhandenen Rubidium - Xenon - Polarisatoren, in denen zum optischen Pumpen teure Diodenlaser mit typischerweise 2 Nanometer Linienbreite eingesetzt werden, nur ein Bruchteil des Laserlichts genutzt.

Die Partialdrucke von Helium betragen in einem Gasgemisch gemäß Stand der Technik zur Zeit bis zu 10 bar. Im Vergleich zu den übrigen Partialdrucken (Xenon bzw. Stickstoff) ist dieser sehr hoch. Dieser relativ hohe Partialdruck bewirkt, daß polarisierte Atome nur selten an die Probenwand der Glaszelle gelangen und dort z. B. durch Wechselwirkung mit paramagnetischen Zentren ihre Polarisation verlieren. Mit zunehmendem Partialdruck des Heliums nimmt die Wahrscheinlichkeit ab, daß polarisierte Atome nachteilhaft an die Zellenwand stoßen.

Um die volle Leistung des Lasers zu nutzen und gleichzeitig nachteilhafte Relaxationseffekte durch Stöße mit der Wand zu reduzieren, müßte bei Helium - Drucken weit oberhalb von 30 bar gearbeitet werden. Beim Stand der Technik ist dies nicht möglich.

Bei der Zusammenstellung des Gasgemisches ist ferner folgendes zu beachten.

Ein polarisiertes Alkaliatom wie z. B. Rubidium vermag eine Fluoreszenzstrahlung zu erzeugen. Wird eine solche Strahlung von einem weiteren polarisierten Alkaliatom eingefangen, so führt dieser Einfang zur Depolarisation des Alkaliatoms. Der bei der Polarisation von Edelgasen eingesetzte Stickstoff im Gasgemisch dient dem Strahlungseinfang dieser Fluoreszenzstrahlung, um die vorgenannte unerwünschte Depolarisation herabzusetzen. Das Element Stickstoff im Gasgemisch weist ebenso wie Xenon nur einen geringen Partialdruck auf. Dieser Partialdruck beträgt typischerweise beim Stand der Technik 0,1 bar.

Die schweren Edelgas - Atome wie z. B. Xenon - Atome verursachen bei Stößen mit den Alkaliatomen eine starke Relaxation der Polarisation der Alkaliatome. Um die Polarisation der Alkaliatome beim optischen Pumpen so groß wie möglich zu halten, muß der Partialdruck des Xenongases im Gasgemisch entsprechend klein sein. Selbst bei einem Xenon - Partialdruck im Gasgemisch von 0,1 bar braucht man Laserleistungen um die 100 Watt, um im ganzen Probenvolumen eine Polarisation der Alkaliatome von 70 Prozent zu erreichen.

Beim Stand der Technik werden Glaszellen eingesetzt, die aus einem Stück Glas geblasen sind. Es war bisher nicht möglich, auf andere Weise eine Glaszelle zu schaffen, die die gewünschten hohen Drucke auszuhalten vermochte. Die vorgenannte Herstellung der Glaszelle hat zur Folge, daß die Fenster, durch die das Licht des Lasers ein- und austritt, stets gekrümmt bzw. abgerundet sind. Es treten beim Eintritt oder Austritt des Lichts des Lasers unerwünschte, nachteilhafte Linseneffekte auf. Das Licht des Lasers wird fokussiert oder aufgeweitet. Hierdurch verschlechtert sich die Effektivität erheblich, Alkaliatome im Gasgemisch der Glaszelle zu polarisieren.

Eine Glaszelle für die Polarisation von Edelgasen soll folgende Anforderungen erfüllen

Sie soll unmagnetisch bzw. resistent gegenüber Alkalimetalen bei Temperaturen von bis zu 200 Grad Celsius und druckfest sein.

Die Glaszelle soll mit Ventilen verschlossen werden können. Die Ventilköpfe sollten 200 Grad Celsius in Anwesenheit von dem Gasgemisch überstehen, außerdem unmagnetisch und druckfest sein. Der Einfluß der Ventile auf die Polarisation des Edelgases sollte so gering wie möglich sein.

Die Oberfläche im Inneren der Zelle soll keinen zerstörenden Einfluß auf die Xenon- bzw. auf die Rubidium - Polarisation haben. Es sollten sich daher keine para- oder gar ferromagnetischen Zentren an der Innenwand der Zelle befinden. Auch sollte das Material, aus dem die Zelle besteht, absolut unmagnetisch sein.

Das Licht des Lasers soll sich möglichst ohne Linseneffekte, d. h. parallel durch die Zelle ausbreiten können.

Das Eintrittsfenster der Zelle soll so wenig wie möglich das Licht des Lasers absorbieren. Anderenfalls wird das Fenster zu stark erhitzt und schließlich zerstört.

Das Eintrittsfenster soll weder bei Normaldruck noch bei hohem Druck doppelbrechend sein. Anderenfalls würde die Zirkularpolarisation des Lasers zerstört oder zumindest gemindert.

Insgesamt ist es also wünschenswert, ein Edelgas bei Drucken von weit über 30 bar zu polarisieren. Die Probenzelle, die aus Glas besteht, sollte durch die hohen Drucke möglichst wenig belastet werden.

Aufgabe der Erfindung ist die Schaffung eines Polarisators für Edelgase, bei dem breitbandige und schmalbandige Laser gleichermaßen in optimaler Weise eingesetzt werden können und der sich weniger storanfällig verhält.

Die Aufgabe der Erfindung wird durch eine Vorrichtung mit den Merkmalen des ersten Anspruchs gelöst. Vorteilhafte Ausgestaltungen ergeben sich aus den Unteransprüchen.

Der Polarisator nach Anspruch 1 umfaßt eine Probenzelle. In die Probenzelle wird ein Gasgemisch hineingeleitet, welches unter anderem Edelgase und Alkaliatome enthält. Mit Hilfe eines Lasers werden die Alkaliatome polarisiert. Die polarisierten Alkaliatome geben ihre Polarisation an die Edelgase ab. Die polarisierten Edelgase werden anschließend insbesondere einer Ausfriereinheit zugeführt. Insbesondere die Edelgase Xenon und Krypton lassen sich bei vertretbarem technischen und finanziellen Aufwand ausfrieren. Die Probenzelle besteht aus Glas und zwar insbesondere aus Borosilikatglas. Die Probenzelle weist vorteilhaft wenigstens ein Eintrittsfenster für den polarisierenden Laserstrahl auf, welches aus Flachglas, insbesondere aus Borofloatglas besteht. Das oder die aus Flachglas bestehenden Fenster sind dann mit dem übrigen Glas der Probenzelle verschmolzen. Leitungen, die in aus der Probenzelle führen, sind ebenfalls aus Glas gefertigt. Die aus Glas bestehenden Elemente der Vorrichtung wie Probenzelle, Vorratsgefäß oder Ausfriereinheit befinden sich in einer Druckkammer. Unter einer Druckkammer wird eine solche verstanden, die einem Druck von 30 bar und mehr gewachsen ist. Die Wände der Kammer bestehen insbesondere aus nichtmagnetischem Edelstahl, da dieses Material besonders stabil und somit gut geeignet ist, den Druck von wenigstens 30 bar auszuhalten. Das genannte Glas sowie der vorteilhafte Aufbau der Probenzelle mit den aus Flachglas bestehenden Fenstern erfüllt in besonderer Weise die eingangs genannten Anforderungen an die Probenzelle.

Im Inneren der Druckkammer wird ein Druck erzeugt, der dem Druck in der Probenzelle entspricht. So wird erreicht, daß das Glas keiner oder nur einer sehr geringen Druckdifferenz ausgesetzt wird. Es ist ohne Probleme möglich, daß die Druckdifferenz wenige bar beträgt. Die gesamte Glasanordnung ist somit einer nur geringen Druckbelastung ausgesetzt. Die Dicke des verwendeten Glases kann gering sein. Die optische Qualität des Fensters, durch das das Licht des Lasers in die Probenzelle gelangt, kann so gesteigert werden.

Es ist ferner problemlos möglich, einen Druck von 30 bar und mehr in der Probenzelle bereitzustellen und im Ergebnis die Aufgabe der Erfindung zu lösen. Der Druck kann so gewählt werden, daß die jeweilige spektrale Breite eines Lasers an die optische Linienbreite des verwendeten Alkaliatoms angepaßt ist. Ferner werden die Polarisation zerstörende Kontakte der Edelgas - Atome bei hohen Drucken von wesentlich mehr als 10 bar mit der Wand vermieden. Insgesamt kann mit dem erfindungsgemäßen Polarisator mit einem vergleichsweise frei wählbaren Druck die Leistung eines bei 10 bar arbeitenden herkömmlichen Polarisators um ein Vielfaches übertroffen werden. Typische Wandstärken des Glases liegen zwischen 2 und 5 mm.

Das Gas in der Probenzelle entspricht hinsichtlich seiner Zusammensetzung im wesentlichen dem Gas in der Druckzelle außerhalb der Probenzelle. Besteht das Gasgemisch in der Probenzelle z. B. im wesentlichen aus Helium, so besteht das Gas in der Druckzelle ebenfalls im wesentlichen oder der Einfachheit halber vollständig aus Helium. Es ist auf diese Weise problemlos möglich, die Probenzelle vor Verunreinigungen wie zum Beispiel Luftsauerstoff zu schützen. Ferner dringt bei kleineren Undichtigkeiten lediglich Helium in die Probenzelle ein, so daß solche Undichtigkeiten unkritisch sind.

Beispielsweise werden Rubidium - Atome am effizientesten dann gepumpt, wenn die spektrale Breite des Lasers genau so groß ist wie die spektrale Breite des optischen Übergangs der Rubidium - Atome. Es ist bekannt, daß bei Verwendung von Heliumgas die Verbreiterung des optischen Übergangs von Alkaliatomen proportional zum Heliumdruck verläuft. Beispielsweise wird die Rubidium D₁ - Linie (794,8 Nanometer) bei einem Heliumdruck von 10 bar auf Δλ = 0,35 Nanometer verbreitert. Bei Verwendung eines Lasers mit einer Leistung von 100 Watt und einer spektralen Breite von 2 Nanometern liegt das Optimum der Effizienz bei ca. 50 bis 60 bar Heliumdruck. Selbst bei Verwendung eines leistungsstarkerl Laserdiodenmoduls (welches aus einer Vielzahl an Laserdioden aufgebaut ist) mit einer spektralen Breite von lediglich einem Nanometer werden 30 bar Druck benötigt, um die Energie des Lasers optimal zur Polarisation zu nutzen. Diese Angaben verdeutlichen, warum die Erhöhung des Drucks auf 30 bar und mehr eine wesentliche Leistungssteigerung zur Folge hat.

In einer vorteilhaften Ausgestaltung der Erfindung ist die Druckkammer daher so ausgelegt, daß sie wenigstens 50 bar Druck verträgt. Insbesondere gilt diese Anforderung auch für die Teile, die ebenfalls diesem Druck ausgesetzt sind. Dies gilt z. B. insbesondere für angeschlossene Rohre, die ebenfalls bevorzugt aus Edelstahl bestehen. Betroffen ist ferner z. B. das Nadelventil, Abschlußventile sowie angeschlossene Meßgeräte wie z. B. ein Druckmeßgerät oder ein Flußmeßgerät, mit dem die Geschwindigkeit des strömenden Gases gemessen wird.

Die Druckkammer ist insbesondere mit einem Deckel versehen, der abgenommen werden kann. Durch die dann offenliegende Kammer können die eigentlichen Elemente des Polarisators in die Druckkammer gebracht oder bei Bedarf ausgetauscht werden.

Vorteilhaft weist die Kammer ferner Bullaugen aus dickem Glas auf. Die Bullaugen sind in der von Taucherglocken her bekannten Weise in die Wände der Druckkammer eingebaut. Zwei Bullaugen können dann als Eintritts- sowie als Austrittsfenster für den Laserstrahl dienen, mit dem die Alkaliatome in der Probenzelle polarisiert werden. Weitere Bullaugen dienen zu Beobachtungszwecken. Über die weiteren Bullaugen kann beispielsweise ein weiterer Laserstrahl zum Beispiel für Testzwecke durch die Probenzelle hindurch gelangen, um anhand der Absorption des Lichts dieses Lasers die Verteilung der Polarisation in der Probenzelle zu messen. Durch ein Bullauge hindurch kann ferner festgestellt werden, wie weit das Ausfrieren von Gas (insbesondere Xenongas) in der Ausfriereinheit fortgeschritten ist.

Werden Bullaugen zur Beobachtung vorgesehen, so ist es von besonderem Vorteil, den Druck in der Druckkammer mit Hilfe von Gasen wie Helium zu erzeugen. Gase wie Helium sind frei von Wasser. So wird vermieden, daß Wasser auf der Ausfriereinheit oder den Bullaugen kondensiert oder sich an der Ausfriereinheit sogar eine Eisschicht bildet. Daher ist in einer vorteilhaften Ausgestaltung der Erfindung die Druckkammer über ein Edelstahlrohr, einen Druckminderer, ein Druckmeßgerät und Ventile mit einem Heliumtank verbunden. Im Heliumtank befindet sich das Heliumgas bei einem Druck von z. B. 150 bar. Mit dem Druckminderer und den Ventilen kann die Druckkammer kontrolliert auf den gewünschten Heliumdruck von z. B. 50 bar gebracht werden.

In einer vorteilhaften Ausgestaltung der Erfindung liegt der in den Glaskomponenten herrschende Druck oberhalb des Drucks in der sonstigen Druckkammer. Die Druckdifferenz beträgt typischerweise 1 bis 2 bar. Auf diese Weise wird weiter sichergestellt, daß keine Verunreinigungen aus der Druckkammer in die Probenzelle usw. gelangen.

Durch das Vorsehen der Druckkammer können die bisher verwendeten Einrichtungen nicht oder nicht ohne weiteres weiter verwendet werden. In der Druckkammer steht in der Regel nur begrenzt Platz zur Verfügung, so daß bisherige Einrichtungen schlecht oder nicht in der Druckkammer untergebracht werden können. Beispielsweise ist der Zugang zur Ausfriereinheit in der geschlossenen Druckkammer erheblich erschwert. In einer vorteilhaften Ausgestaltung der Erfindung ist daher in einer Wand der Druckkammer ein Metallstab z. B. eingeschraubt. Dieser Metallstab besteht insbesondere aus einem Metall wie z. B. Kupfer, welches besonders gut Wärme zu leiten vermag. Das eine Ende des Metallstabes berührt einen Teil der Ausfriereinheit. Am anderen Ende des Metallstabes, welcher von außen (außerhalb der Druckkammer) zugänglich ist, befinden sich Mittel zur Kühlung. Als Mittel zur Kühlung wird insbesondere flüssiger Stickstoff eingesetzt. Aufgrund der Wärmeleitfähigkeit des Metalls wird die Temperatur bei der Ausfriereinheit nicht wesentlich von der Temperatur des flüssigen Stickstoffs (77 Kelvin) abweichen. Durch diese Ausgestaltung der Erfindung ist die Kühlung der Ausfriereinheit also auf einfache Weise möglich.

In dem Bereich, in dem das Edelgas in der Ausfriereinheit ausgefroren wird, sind Magnete angeordnet. Mit diesen Magneten wird ein Magnetfeld oberhalb von 1000 Gauss erzeugt. Insbesondere beträgt die Stärke des Magnetfeldes 2000 Gauss. Es werden zum Beispiel Magnete eingesetzt, die aus Neodym - Eisen - Bor bestehen und/oder die Form von Backenmagneten aufweisen. Mit solchen Magneten können die gewünschten hohen Magnetfeldstärken erzielt werden. Durch das Magnetfeld wird verhindert, daß die Polarisation des Edelgases im Eiszustand zerfällt. Beispielsweise beträgt bei einer Temperatur von 77 Kelvin und einem Magnetfeld von 2000 Gauss die (T₁-) Relaxationszeit von polarisiertem Xenon ca. ein bis zwei Stunden.

Um beispielsweise ein Gramm polarisiertes Xenon - Eis in einem Polarisator gemäß Stand der Technik herzustellen, wird eine Zeit von einer halben bis einer ganzen Stunde benötigt. Wegen der weit höheren Effizienz des erfindungsgemäßen Polarisators kann z. B. ein Gramm polarisiertes Xenon-Eis in etwa.10 Minuten erhalten werden. In dieser Zeit ist der Verlust der Xenon - Polarisation vernachlässigbar. Die erfindungsgemäße Vorrichtung ist also nicht nur aufgrund der höheren Ausbeute von Vorteil, sondern auch deshalb, weil mit dieser sehr schnell produziert werden kann.

Selbstverständlich ist es auch möglich, den Metallstab mit Hilfe eines Helium - Kryostaten auf ca. 20 Kelvin zu kühlen. Bei 20 Kelvin beträgt die Relaxationszeit der Polarisation des Xenon - Eises ca. einen Tag. Xenon kann in diesem Zustand also länger gespeichert bzw. akkumuliert werden.

Am anderen Ende des Metallstabes, welcher von außen (außerhalb der Druckkammer) zugänglich ist, befinden sich in einer weiteren vorteilhaften Ausgestaltung der Erfindung Mittel zum Heizen des Metallstabes. Durch das Heizen des Metallstabes wird das in der Ausfriereinheit befindliche Xenon - Eis rasch erwärmt. Die Erfinder haben nämlich festgestellt, daß bei langsamem Auftauen des Xenon - Eises ein großer Teil der Polarisation verlorengeht. Mit Hilfe der Mittel zum Heizen des Metallstabes wird der Vorgang erheblich beschleunigt. Polarisationsverluste werden so weiter vermieden.

Beim Stand der Technik wird die Probenzelle und das Vorratsgefäß mit heißer Luft erhitzt. Dieses Verfahren wird in Rubidium - Xenon - Polarisatoren vor allem deshalb eingesetzt, weil es am Ort der Probe nur geringe Magnetfelder erzeugt. Heiße Luft wird über einen langen Schlauch an den Ort der Probe bzw. an den Ort der Probenzelle transportiert. Dieses Verfahren zum Heizen ist innerhalb einer Hochdruckkammer kaum zu realisieren. Daher ist es in einer weiteren Ausgestaltung der Erfindung vorteilhaft, das Heizen nach einem der folgenden Verfahren bzw. mit Hilfe einer der folgenden Vorrichtungen durchzuführen.

In einer nächsten Ausgestaltung der Erfindung wird das Vorratsgefäß und das Eintrittsfenster der Probenzelle mit einer Hochfrequenz - Heizung lokal erhitzt. Das Eintrittsfenster wird beheizt, damit sich Rubidium - Metall nicht auf dem Eintrittsfenster abscheiden kann. Andernfalls würde das Licht des Lasers nachteilhaft beeinträchtigt. Die Hochfrequenz - Heizung wird zum Beispiel durch einen Heizdraht, die um das Vorratsgefäß sowie um das Eintrittsfenster der Probenzelle gewickelt ist, realisiert.

Durch die Hochfrequenz - Heizung wird gezielt nur der Teil beheizt, der zur Erzielung der gewünschten Wirkungen beheizt werden muß. Das Heizen erfolgt somit effektiv.

Durch eine Hochfrequenz - Heizung werden elektrisch leitfähige Oberflächen erwärmt und somit das Rubidium - Metall in dem Vorratsgefäß erhitzt. Um die Effektivität der Heizung weiter zu verbessern, wird in einer weiteren vorteilhaften Ausgestaltung der Erfindung das Alkalimetall auf ein Drahtgeflecht, das insbesondere aus Kupfer besteht, innerhalb des Vorratsgefäßes aufgebracht. Das Metall, aus dem das Drahtgeflecht besteht, sollte nicht magnetisch sein, und es sollte sich ferner um ein Edelmetall handeln. In Betracht kommt daher beispielsweise ferner Platin oder Silber als Werkstoff. Durch diese Ausgestaltung der Erfindung wird die Oberfläche des Rubidium - Metalls wesentlich vergrößert. Als Folge wird die benötigte Heizleistung stark reduziert.

Die Frequenz, mit der die Hochfrequenz -Heizung betrieben wird, ist so zu wählen, daß die Grundfrequenz und die harmonischen bzw. subharmonischen Frequenzen sich wesentlich von der Resonanzfrequenz von dem zu polarisierenden Edelgas, also zum Beispiel von Xenon unterscheiden. Andernfalls würde die Polarisation des Edelgases zerstört werden. Beispielsweise beträgt die Resonanzfrequenz von Xenon typischerweise 10 bis 50 kHz. Typische Frequenzen für den Betrieb der HF-Heizung liegen bei 1 bis 2 MHz.

In einer weiteren Ausgestaltung der Erfindung wird das Allkalimetall in dem Vorratsgefäß durch Erhitzen mittels eines Lasers verdampft. Besonders gut geeignet sind breitbandige Laser von z. B. 4 bis 5 Nanometern, die insbesondere eine Wellenlänge von ca. 795 Nanometer aufweisen. Die Leistung eines solchen Lasers beträgt typischerweise 30 Watt. Als Laser wird insbesondere ein Diodebarren eingesetzt, da dieser preiswert ist. Vorteilhaft wird das Licht des Lasers mit Hilfe von Linsen fokussiert. Das Licht des Lasers wird zum Beispiel durch ein Beobachtungsfenster hindurch auf das Rubidium - Metall im Vorratsgefäß gelenkt. Das Heizen mit Hilfe eines Lasers weist den Vorteil auf, daß keine störenden magnetischen Felder erzeugt werden. Es muß ferner kein Draht und dergleichen in die Hochdruckkammer hineingeführt werden.

In einer weiteren vorteilhaften Ausgestaltung der Erfindung sind Mittel vorgesehen, die die Gaszuleitung zur Probenzelle erwärmen. Hierdurch wird die Gasmischung erwärmt, die dem Vorratsgefäß bzw. der Probenzelle zugeführt wird. Als Mittel zur Erwärmung der Zuleitung ist insbesondere ein Ölbad vorgesehen, das zum Beispiel mit einer elektrischen Heizung auf eine gewünschte Temperatur gebracht wird. Wird beispielsweise Siliconöl vorgesehen, so kann dieses Bad auf bis zu 200 Grad Celsius erhitzt werden.

Bei diesem Verfahren so wie bei dem Heizverfahren mittels Laser ist problematisch, daß ein nachteilhafter Niederschlag auf dem Eintrittsfenster in der Probenzelle stattfinden kann. Zur Lösung dieses Problems ist bei einer weiteren Ausgestaltung der Erfindung eine Dotierung des Eintrittsfensters vorgesehen, durch die das Licht des Lasers verstärkt absorbiert wird. Dann erhitzt sich automatisch das Eintrittsfenster und der unerwünschte Niederschlag wird verhindert.

Chrom ist ein geeigneter Stoff, mit dem das Fenster vorteilhaft dotiert werden kann, damit das Fenster sich in vorgenannter Weise erwärmt.

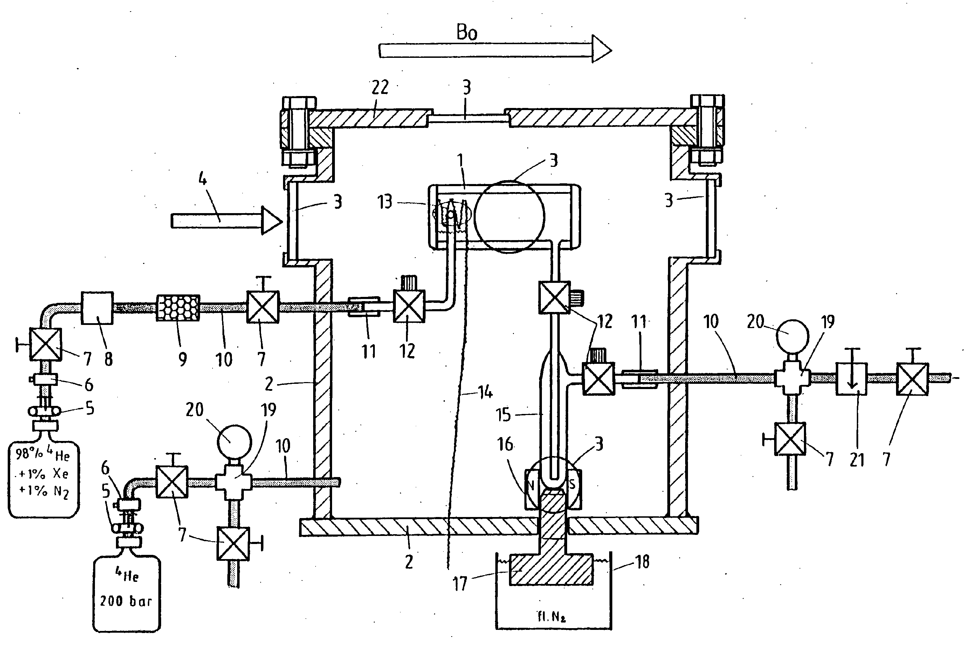

Die Figur verdeutlicht den grundsätzlichen Aufbau einer Ausführungsform der Erfindung.

Eine Probenzelle 1 befindet sich in einem Druckgefäß bzw. einem Druckbehälter 2. Der Druckbehälter 2 ist aus nichtmagnetischem V4A-Stahl gefertigt. Der Druckbehälter 2 weist Sichtfenster 3 in Form von Bullaugen auf. Außerhalb des Druckbehälters 2 befindet sich ein Laser, dessen Licht 4 durch ein erstes Sichtfenster 3 in das Innere des Druckbehälters 2 gelangt, anschließend die Probenzelle 1 passiert und über ein weiteres Sichtfenster 3 den Druckbehälter 2 wieder verläßt.

Ein Gasgemisch wird in die Probenzelle 1 eingeleitet. Das Gasgemisch befindet sich in einem Vorratsbehälter bei einem Druck von 150 bar. Es ist zum Beispiel wie folgt zusammengesetzt: 98 Vol.-% ⁴Helium, 1 Vol.-% Xenon, 1 Vol.-% Stickstoff. Das Gasgemisch wird über eine Leitung zunächst einem Druckminderer 5 zugeführt. Von hieraus gelangt es zu einem Überströmventil 6. Dem Überströmventil 6 ist ein Absperrventil 7 nachgeschaltet. Anschließend durchläuft das Gasgemisch ein Flußmeßgerät 8, mit dem die Menge des strömenden Gases gemessen werden kann. Dann passiert das Gasgemisch einen Gasreiniger 9 und gelangt nachfolgend zu einem weiteren Absperrventil 7. Die zugehörigen Rohrleitungen 10 sind aus V4A-Stahl gefertigt und weisen einen Innendurchmesser von 3 mm auf. Das Rohr 10 führt durch eine Wand des Druckbehälters 2 hindurch. Ein Verbindungsstück 11 verbindet das Rohr 10 mit einer Glasleitung. Die Glasleitung mündet zunächst in ein aus Glas bestehendes Absperrventil 12 ein. Von hieraus führt die Glasleitung weiter zu einem Vorratsbehälter bzw. einem Vorratsgefäß 13. Um das Vorratsgefäß 13 ist eine Heizwicklung 14 gewickelt. Die Heizwicklung 14 wird mit einem Hochfrequenzstrom betrieben. Dann wird das Vorratsgefäß 13 beheizt. Im Vorratsgefäß 13 befindet sich während des Betriebes Alkalimetall, welches hier verdampft wird. Das verdampfte Alkalimetall gelangt zusammen mit dem vorgenannten Gasgemisch in die Probenzelle 1.

In der Probenzelle 1 findet in vorbeschriebener Weise die Polarisation der Alkaliatome bzw. des Edelgases statt. Das Gasgemisch wird anschließend aus der Probenzelle herausgeleitet und gelangt zunächst zu einem weiteren Glasabsperrventil 12. An dieses weitere Glasabsperrventil 12 schließt sich eine Ausfriereinheit 15 an. Am unteren Ende der Ausfriereinheit 15 ist ein Permanentmagnet 16 angeordnet. Mit Hilfe des Permanentmagneten 16 wird das Gasgemisch mit den polarisierten Edelgasatomen einem starken Magnetfeld ausgesetzt. Nachteilhafte Relaxationserscheinungen werden so herabgesetzt. Ein aus Kupfer bestehender Stab 17, hier auch Kupferfinger genannt, führt aus dem Druckbehälter 2 heraus und ist außerhalb des Druckbehälters 2 in flüssigen Stickstoff eingetaucht. Der Stickstoff befindet sich in einem Dewargefäß 18. Der Kupferfinger 17 berührt das Ende der Ausfriereinheit 15, welches sich in dem homogenen Bereich des starken Magnetfeldes befindet. Auf diese Weise wird dieses Ende der Ausfriereinheit so stark gekühlt, daß das polarisierte Edelgas in dem starken Magnetfeld ausfriert.

Das Restgas wird von der Ausfriereinheit 15 über ein Glasabsperrventil 12, ein Verbindungsstück 11, ein aus V4A-bestehendes Rohr 10 aus dem Druckbehälter 2 herausgeleitet. Das Gasgemisch gelangt dann zu einem Kreuzstück 19, welches an einen Druckmesser 20, ein Absperrventil 7 und ein Nadelventil 21 angeschlossen ist. Durch das Nadelventil 21 wird der Abfluß reguliert. Mit Hilfe der in der Figur gezeigten beiden Druckmesser 20 werden der herrschende Druck innerhalb der Druckkammer bzw. der Glaseinheit kontrolliert. Hinter dem Nadelventil 21 ist ein weiteres Absperrventil 7 angeordnet. In einer weiteren Gasflasche bzw. einem Gasbehälter befindet sich ⁴Helium bei einem Druck von 200 bar. Über einen Druckminderer 5, ein Überströmventil 6 sowie ein Kreuzstück 19 wird das Heliumgas durch ein aus V4A-bestehendes Rohr in das Druckgefäß 2 eingeleitet. Das Kreuzstück 19 ist noch mit einem Druckmesser 20 verbunden, um den Druck kontrollieren zu können. Ferner führt eine Leitung vom Kreuzstück 19 zu einem Absperrventil 7. Auf diese Weise kann im Inneren des Druckbehälters 2 außerhalb der Probenzelle ein Betriebsdruck von bis zu 50 bar erzeugt werden. Dieser Druck wird durch das Heliumgas bereitgestellt. Im Inneren der Probenzelle 1 kann dann ein vergleichbar hoher Betriebsdruck vorteilhaft bereitgestellt werden. Das Druckgefäß 2 weist einen Deckel 22 auf, der geöffnet werden kann, um bei Bedarf Teile der Polarisationseinrichtung zu entnehmen oder auszutauschen.

## Patentansprüche

1. Polarisator für die Polarisation von Kernspins eines Edelgases durch Spinaustausch mit optisch angeregten Alkalimetallatomen mit aus Glas bestehenden Einrichtungen (1, 11, 12, 13, 15), zu denen auch eine Probenzelle (1) gehört, mit einer Druckkammer (2), in der sich die aus Glas bestehenden Einrichtungen befinden,
**dadurch gekennzeichnet, dass**
die Zusammensetzung des in der Probenzelle befindlichen Gases der Zusammensetzung des Gases im wesentlichen entspricht, welches sich außerhalb der Zelle in der Druckkammer befindet, das heißt, falls das Gasgemisch in der Probenzelle beispielsweise im wesentlichen aus Helium besteht, so besteht das Gas in der Druckzelle ebenfalls im wesentlichen oder sogar vollständig aus Helium.

2. Polarisator nach Anspruch 1,
**gekennzeichnet durch**
- eine in der Druckkammer befindliche Ausfriereinheit (15), die mit der Probenzelle (1) über ein aus Glas bestehendes Rohr verbunden ist,
- einen mit einer Wand der Druckkammer verbundenen Metallstab (17), der wenigstens an einen Teil der Ausfriereinheit (15) grenzt,
- eine Kühleinrichtung außerhalb der Druckkammer, die den Stab kühlt, oder einer Kühl- und Heizeinrichtung (18) außerhalb der Druckkammer, die den Stab (17) kühlt oder heizt.

3. Polarisator nach Anspruch 1 oder 2, bei dem die Druckkammer (2) eine Mehrzahl an Bullaugen (3) aufweist.

4. Polarisator nach einem der vorhergehenden Ansprüche, bei dem eine Hochfrequenz - Heizung vorgesehen ist, mit der ein Eintrittsfenster der Probenzelle und / oder ein Vorratsgefäß (13), in dem sich Alkalimetall befindet, beheizt wird.

5. Polarisator nach einem der vorhergehenden Ansprüche, bei dem ein als Hochfrequenz - Heizung dienender Draht (14) am Rand eines Eintrittsfensters der Probenzelle und / oder um ein Vorratsgefäß (13) für Alkalimetall gewickelt ist.

6. Polarisator nach einem der vorhergehenden Ansprüche, bei dem ein Vorratsgefäß (13) mit der Probenzelle (1) über eine aus Glas bestehende Leitung verbunden ist, wobei in dem Vorratsgefäß sich ein aus Metall bestehendes poröses Substrat, insbesondere ein Drahtgeflecht befindet, auf dem Alkalimetall aufgebracht ist.

7. Polarisator nach einem der vorhergehenden Ansprüche, bei dem ein Laser zum Beheizen eines vorratsgefäßes (13) vorgesehen ist, in dem sich Alkalimetall befindet.

8. Polarisator nach einem der vorhergehenden Ansprüche, bei dem Mittel vorgesehen sind, die die Gaszuleitung zu einem Vorratsgefäß für Alkalimetall erwärmen, wobei das Vorratsgefäß der Probenzelle vorgeschaltet ist.

9. Polarisator nach einem der vorhergehenden Ansprüche, bei dem als Mittel zur Beheizung der Gaszuleitung zur Probenzelle ein Ölbad vorgesehen ist.

10. Polarisator nach einem der vorhergehenden Ansprüche, bei dem das Eintrittsfenster zur Probenzelle mit Dotierstoffen zur Absorption von Licht versehen ist.

## Claims

1. Polariser, for polarising nuclear spins of a noble gas by spin exchange with optically excited alkali metal atoms, having devices (1, 11, 12, 13, 15) comprised of glass which also comprise a sample cell (1), with a pressure chamber (2) wherein the devices comprised of glass are located,
**characterised in that**
the composition of the gas located in the sample cell substantially corresponds to the composition of the gas located outside the cell in the pressure chamber, that is, if the gas mixture in the sample cell is substantially comprised, for example, of helium, then the gas in the pressure cell is also comprised, substantially or even entirely, of helium.

2. Polariser according to claim 1,
**characterised by**
- a freezing-out unit (15), which is located in the pressure chamber and connected with the sample cell (1) through a pipe comprised of glass,
- a metal rod (1 7) connected with a wall of the pressure chamber and adjoining at least a part of the freezing-out unit (15),
- a cooling device outside of the pressure chamber, which cools the rod, or a cooling and heating device (18) outside of the pressure chamber, which cools or heats the rod (1 7).

3. Polariser according to claim 1 or 2, wherein the pressure chamber (2) has a plurality of port holes (3).

4. Polariser according to one of the preceding claims, wherein a high-frequency heating is provided with which an entrance window of the sample cell and/or a storage vessel (1 3), in which an alkali metal is located, is heated.

5. Polariser according to one of the preceding claims, wherein a wire (14) serving as a high-frequency heating is wound at the edge of the entrance window of the sample cell and/or around a storage vessel (13) for alkali metal.

6. Polariser according to one of the preceding claims, wherein a storage vessel (13) is connected with the sample cell (1) over a line comprised of glass, a porous substrate comprised of metal, in particular a wire mesh, on which alkali metal is deposited, being located in the storage vessel.

7. Polariser according to one of the preceding claims, wherein a laser is provided for heating a storage vessel (13) in which alkali metal is located.

8. Polariser according to one of the preceding claims, wherein means are provided that heat the gas feed to a storage vessel for alkali metal, the storage vessel being disposed upstream from the sample cell.

9. Polariser according to one of the preceding claims, wherein an oil bath is provided as means for heating the gas feed to the sample cell.

10. Polariser according to one of the preceding claims, wherein the entrance window to the sample cell is provided with dopants for absorbing light.

## Revendications

1. Polarisateur pour la polarisation du spin nucléaire d'un gaz rare par échange de spin avec des atomes de métal alcalin excités optiquement, avec des dispositifs consistant en du verre (1, 11, 12, 13, 15), dont fait également partie une cellule d'échantillonnage (1), avec une chambre de compression (2), dans laquelle se trouvent également les dispositifs consistant en du verre,
**caractérisé en ce que** la composition du gaz qui se trouve dans la cellule d'échantillonnage correspond sensiblement à la composition du gaz qui se trouve à l'extérieur de la cellule, dans la chambre de compression, c'est-à-dire que si le mélange gazeux consiste par exemple en majeure partie en de l'hélium, le gaz dans la chambre de compression consiste également en majeure partie ou totalement en de l'hélium.

2. Polarisateur selon la revendication 1, **caractérisé par**
- une unité de séparation par congélation (15) située dans la chambre de compression, qui est reliée avec la cellule d'échantillonnage (1) par l'intermédiaire d'un tube consistant en du verre,
- une tige métallique (17) reliée à la chambre de compression, qui est adjacente à au moins une partie de l'unité de séparation par congélation (15),
- un dispositif de refroidissement à l'extérieur de la chambre de compression, qui refroidit la tige ou un dispositif de refroidissement et de chauffage (18) à l'extérieur de la chambre de compression, qui refroidit ou chauffe la tige (17).

3. Polarisateur selon la revendication 1 ou 2, dans lequel la chambre de compression (2) comporte une pluralité de hublot (3).

4. Polarisateur selon l'une quelconque des revendications précédentes, dans lequel est prévu un chauffage haute fréquence, à l'aide duquel est chauffé(e) une fenêtre d'entrée de la cellule d'échantillonnage et/ou un récipient de réserve (13) pour du métal alcalin.

5. Polarisateur selon l'une quelconque des revendications précédentes, dans lequel un fil métallique (14) servant de chauffage haute fréquence est enroulé sur le bord d'une fenêtre d'entrée de la cellule d'échantillonnage et/ou autour d'un récipient de réserve (13) pour du métal alcalin.

6. Polarisateur selon l'une quelconque des revendications précédentes, dans lequel un récipient de réserve (13) est relié à la cellule d'échantillonnage (1) par l'intermédiaire d'un conduit consistant en du verre, un substrat métallique poreux, notamment un treillis métallique, sur lequel est appliqué du métal alcalin se trouvant dans le récipient de réserve.

7. Polarisateur selon l'une quelconque des revendications précédentes, dans lequel est prévu un laser pour chauffer un récipient de réserve (13), dans lequel se trouve du métal alcalin.

8. Polarisateur selon l'une quelconque des revendications précédentes, dans lequel sont prévus des moyens qui chauffent le conduit d'alimentation en gaz vers un récipient de réserve pour du métal alcalin, le récipient de réserve étant monté en amont de la chambre d'échantillonnage.

9. Polarisateur selon l'une quelconque des revendications précédentes, dans lequel un bain d'huile est prévu en tant que moyen pour chauffer la conduite d'alimentation en gaz vers la cellule d'échantillonnage.

10. Polarisateur selon l'une quelconque des revendications précédentes, dans lequel la fenêtre d'entrée sur la cellule d'échantillonnage est munie de substances de dopage pour l'absorption de lumière.
